# EUROPÄISCHE PATENTSCHRIFT

(11) **EP 2 140 281 B1**
(45) Veröffentlichungstag und Bekanntmachung des Hinweises auf die Patenterteilung: **23.06.2010**
(21) Anmeldenummer: 08707477.9
(22) Anmeldetag: 31.01.2008
(51) Int. Cl.: G01R 35/00, H01R 13/646

(54) **KALIBRIERADAPTER**
CALIBRATION ADAPTER
ADAPTATEUR D'ÉTALONNAGE

(30) Priorität: 23.03.2007 DE 202007004296 U
(43) Veröffentlichungstag der Anmeldung: 06.01.2010
(73) Patentinhaber: Rosenberger Hochfrequenztechnik GmbH & Co. KG, 83413 Fridolfing (DE)
(72) Erfinder: WEISS, Frank, 02994 Bernsdorf (DE)
(74) Vertreter: Zeitler - Volpert - Kandlbinder
(86) Internationale Anmeldenummer: PCT/EP2008/000790
(87) Internationale Veröffentlichungsnummer: WO 2008/116522

(56) Entgegenhaltungen:
- DE-U1-202004 013 305
- US-A- 4 967 173
- US-A- 5 091 709
- US-A1- 2004 051 538

## Beschreibung

Die vorliegende Erfindung betrifft ein Kalibrieradapter mit einem Koaxialverbinder, insbesondere Koaxialstecker oder Koaxialbuchse bzw. Koaxialkuppler, zum Anschluss an einen Koaxialverbinder eines zu kalibrierenden Gerätes, insbesondere an ein Messtor eines vektoriellen Netzwerkanalysators (VNA), wobei der Koaxialverbinder ein Innenleiterteil, ein koaxial dazu angeordnetes Außenleiterteil sowie ein mit dem Koaxialverbinder des zu kalibrierenden Gerätes verbindbares steckseitiges Ende aufweist, gemäß dem Oberbegriff des Anspruchs 1.

Die hohe Genauigkeit von vektoriellen Netzwerkanalysatoren (VNA) beruht darauf, dass der Netzwerkanalysator vor der eigentlichen Messung von Betrag und Phase des komplexen Reflexionskoeffizienten durch Anschalten von Kalibrierstandards an seine Messtore kalibriert wird. Zwischenzeitlich gibt es eine Vielzahl von unterschiedlichen Kalibriermethoden. Die meisten Kalibriermethoden benutzen zur Systemkalibrierung Leerlauf-, Kurzschluss- und Anpassungs-Kalibrierstandards. Durch Anschluss dieser Kalibrierstandards an die Messtore des Netzwerkanalysators können die im Netzwerkanalysator entstehenden Fehler, die zu einer Abweichung der Messwerte vom wahren Wert führen, ermittelt und bei der anschließenden Objektmessung zur rechnerischen Fehlerkorrektur benutzt werden. Dies ist beispielsweise aus der DE 39 12 795 A1 bekannt.

Ein beispielhafter Kalibrierstandard mit kurzgeschlossener Präzisionsluftleitung ist beispielsweise aus der DE 20 2004 013 305 bekannt. Mittels eines lösbaren Kurzschlusses zwischen Innenleiterteil und Außenleiterteil in Verbindung mit einem Verstellmechanismus steht ein hoch qualitatives Präzisionsmessmittel für ein exakt einstellbares Versatzmaß zwischen dem Innenleiter und der Referenzebene (Stirnkontaktfläche des Außenleiters) des Koaxialkupplers des Kalibrierstandards zur Verfügung, welches an beliebige Versatzmaße zwischen Stirnkontaktflächen von Außenleiter und Innenleiter am Koaxialkuppler des zu kalibrierenden Gerätes anpassbar ist und auch Bauteiltoleranzen in dem Versatzmaß ausgleicht.

Der Erfindung liegt die Aufgabe zugrunde, einen Kalibrieradapter der o.g. Art zu verbessern.

Diese Aufgabe wird erfindungsgemäß durch einen Kalibrieradapter der o.g. Art mit den in Anspruch 1 gekennzeichneten Merkmalen gelöst. Vorteilhafte Ausgestaltungen der Erfindung sind in den weiteren Ansprüchen beschrieben.

Bei einem Kalibrieradapter der o.g. Art ist es erfindungsgemäß vorgesehen, dass der Kalibrieradapter eine Trommel aufweist, in der wenigstens zwei Kalibrierstandards angeordnet sind, wobei die Trommel drehbar auf einem Stift angeordnet ist, welcher zentrisch mit einer ersten Kappe derart verbunden ist, dass eine Längsachse des Stiftes mit einer Längsachse der ersten Kappe fluchtet, wobei der Koaxialverbinder mit einem dem steckseitigen Ende gegenüberliegenden zweiten Ende exzentrisch zur Längsachse der ersten Kappe mit der ersten Kappe verbunden ist und die Kalibrierstandards in der Trommel derart angeordnet sind, dass durch Drehen der Trommel relativ zur ersten Kappe das dem steckseitigen Ende gegenüberliegende zweite Ende des Koaxialverbinders wahlweise mit einem der Kalibrierstandards verbindbar ist.

Dies hat den Vorteil, dass mit einer einmaligen Verbindung des Kalibrieradapters mit einem Koaxialverbinders eines zu kalibrierenden Gerätes mehrere verschiedene Kalibrierstandards zur Verfügung stehen, ohne dass am Koaxialverbinder des zu kalibrierenden Gerätes für jeden Kalibrieradapter ein neues Teil angesteckt werden muss. Somit können verschiedene Kalibrierstandards mit ein und derselben, unveränderten Steckverbindung angewendet werden, was die Genauigkeit der Kalibrierung erhöht. Gleichzeitig ist der Aufbau des Kalibrieradapters mechanisch einfach sowie kostengünstig und der Kalibrieradapter leicht zu bedienen. Zusätzlich ergeben sich verbesserte elektrische Eigenschaften.

In einer bevorzugten Ausführungsform weist die Trommel vier verschiedene Kalibrierstandards auf.

Üblicherweise umfassen die Kalibrierstandards einen Kurzschluss, welcher das Innenleiterteil des Koaxialverbinders mit dem Außenleiterteil des Koaxialverbinders elektrisch kurz schließt, einen Leerlauf, einen Abschlusswiderstand und/oder einen Fehlabschluss.

Zweckmäßigerweise sind die Kalibrierstandards in der Trommel in Umfangsrichtung gleichmäßig voneinander beabstandet angeordnet.

In einer bevorzugten Ausführungsform ist das Außenleiterteil mit der ersten Kappe verschraubt.

Zweckmäßigerweise ist die erste Kappe mit dem Stift verschraubt.

In einer bevorzugten Weiterbildung der Erfindung ist der Stift an einem von der ersten Kappe abgewandten Ende mit einer zweiten Kappe verschraubt.

Ein Andruck der Trommel in Richtung der ersten Kappe und damit eines der Kalibrierstandards an das zweite Ende des Koaxialverbinders erzielt man dadurch, dass eine elastische Federvorrichtung vorgesehen ist, welche die zweite Kappe und die Trommel in axialer Richtung voneinander weg mit Kraft beaufschlagen. Diese Federvorrichtung ist beispielsweise eine Schraubenfeder ist, welche koaxial zum Stift angeordnet.

Zur Führung der Trommel weist diese bevorzugt eine sich in axialer Richtung erstreckende, buchsenförmige Verlängerung auf, welche in die zweite Kappe eingreift.

Um ein möglichst reibungsfreies Gleiten beim Drehen der Trommel relativ zum Stift sowie zur zweiten Kappe zu erzielen, ist zwischen der buchsenförmigen Verlängerung der Trommel und der zweiten Kappe ein zweites Gleitteil und zwischen der Trommel und dem Stift ein erstes Gleitteil angeordnet.

Dadurch, dass zwischen der ersten Kappe und der Trommel ein Federelement radial beabstandet von dem Stift angeordnet ist, welches die Trommel und die erste Kappe von einander weg mit Kraft beaufschlagt, ergibt sich eine relativ zum Stift asymmetrisch auf die Trommel wirkende Kraft, die die Trommel relativ zum Stift sowie zur ersten Kappe aus der nicht fluchtenden Stellung verkippt und dadurch einen Kontaktdruck zwischen einem der in der Trommel angeordneten Kalibrierstandards und dem zweiten Ende des Koaxialverbinders verbessert. Besonders vorteilhaft ist dabei das Federelement radial gegenüberliegend zum Koaxialverbinder angeordnet und an der ersten Kappe befestigt.

Einen besonders kostengünstigen sowie funktionssicheren Kalibrieradapter erzielt man dadurch, dass wenigstens einer der Kalibrierstandards einstückig mit der Trommel ausgebildet ist.

Zweckmäßigerweise ist der Koaxialverbinder derart mit der ersten Kappe verbunden, dass eine Längsachse des Koaxialverbinders parallel zu einer Längsachse der ersten Kappe verläuft.

Um ein seitliches Anschlagen und ggf. Abscheren des Innenleiterteils am Rand einer der Ausnehmungen für die Kalibrierstandards beim Drehen der Trommel relativ zur ersten Kappe zu verhindern, ist an einer der ersten Kappe zugewandten Seite der Trommel eine Ringnut ausgebildet, welche Aussparungen in der Trommel für die Kalibrierstandards miteinander verbindet und einen Freiraum für das Innenleiterteil zur Verfügung stellt.

Die Erfindung wird im Folgenden anhand der Zeichnung näher erläutert. Diese zeigt in:
- Fig. 1: eine bevorzugte Ausführungsform eines erfindungsgemäßen Kalibrieradapters in Explosionsdarstellung,
- Fig. 2: das Kalibrieradapter gemäß Fig. 1 in Schnittansicht,
- Fig. 3: eine Trommel des Kalibrieradapters gemäß Fig. 1 und 2 in perspektivischer Ansicht,
- Fig. 4: die Trommel gemäß Fig. 3 in Aufsicht,
- Fig. 5: die Trommel gemäß Fig. 3 in Schnittansicht,
- Fig. 6: eine Schnittansicht des Kalibrieradapters gemäß Fig. 1 und 2 mit einem Kalibrierstandard in Form eines Abschlusses,
- Fig. 7: eine Schnittansicht des Kalibrieradapters gemäß Fig. 1 und 2 mit einem Kalibrierstandard in Form eines Fehlabschlusses,
- Fig. 8: eine Schnittansicht des Kalibrieradapters gemäß Fig. 1 und 2 mit einem Kalibrierstandard in Form eines Kurzschlusses und
- Fig. 9: eine Schnittansicht des Kalibrieradapters gemäß Fig. 1 und 2 mit einem Kalibrierstandard in Form eines Leerlaufs.

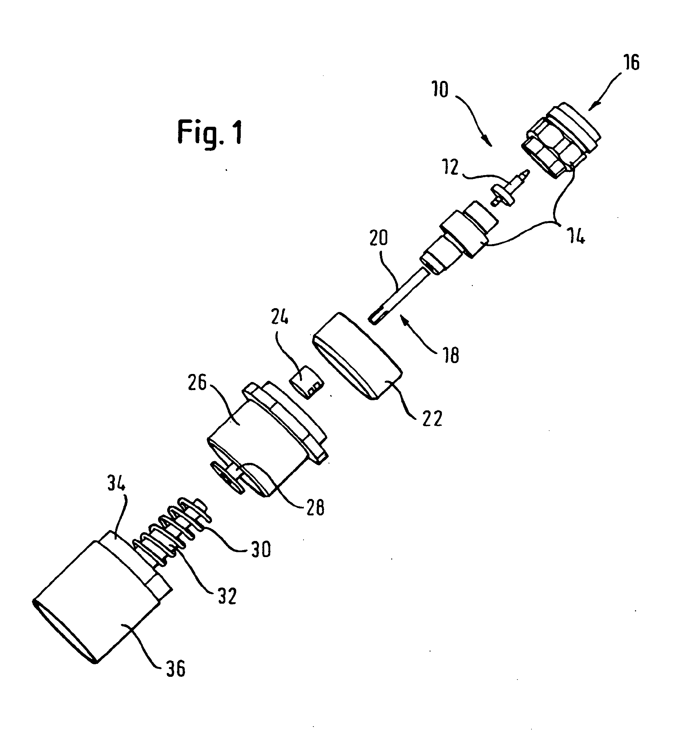

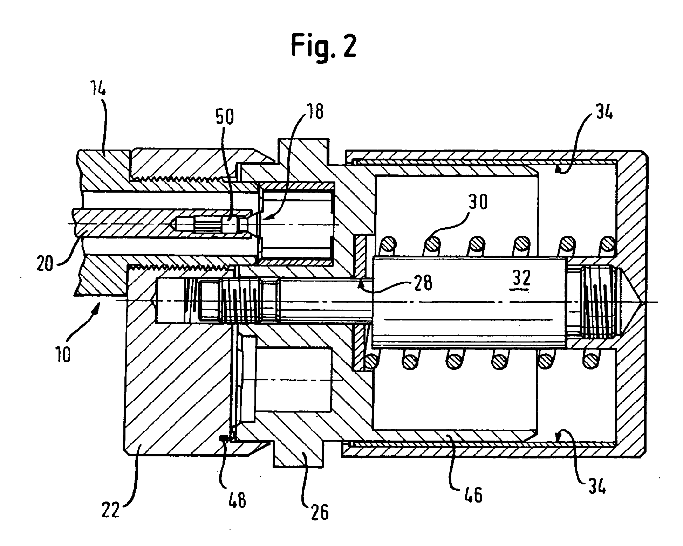

Die in Fig. 1 und 2 dargestellt, bevorzugte Ausführungsform eines erfindungsgemäßen Kalibrieradapters umfasst einen Koaxialverbinder 10, der ein Innenleiterteil 12, ein Außenleiterteil 14, ein steckseitiges Ende 16 sowie ein dem steckseitigen Ende 16 gegenüberliegendes zweites Ende 18 aufweist, einen Kontaktstift 20, eine erste Kappe 22, ein Element 24 für einen Kalibrierstandard, eine Trommel 26, in dem vier Kalibrierstandards angeordnet sind, ein erstes Gleitteil 28, eine Druckfeder 30, einen Stift 32, ein zweites Gleitteil 34 und eine zweite Kappe 36.

Der Stift 32 ist zentrisch mit der ersten Kappe 22 derart verbunden, dass eine Längsachse des Stiftes 32 mit einer Längsachse der ersten Kappe 22 fluchtet. Die Trommel 26 ist drehbar auf dem Stift 32 angeordnet. Der Koaxialverbinder 10 ist mit dem zweiten Ende 18 exzentrisch zur, d.h. radial beabstandet von der Längsachse der ersten Kappe 22 mit der ersten Kappe 22 verbunden. Der Koaxialverbinder 10 ist mit seinem zweiten Ende 18 mit der ersten Kappe 22 verschraubt.

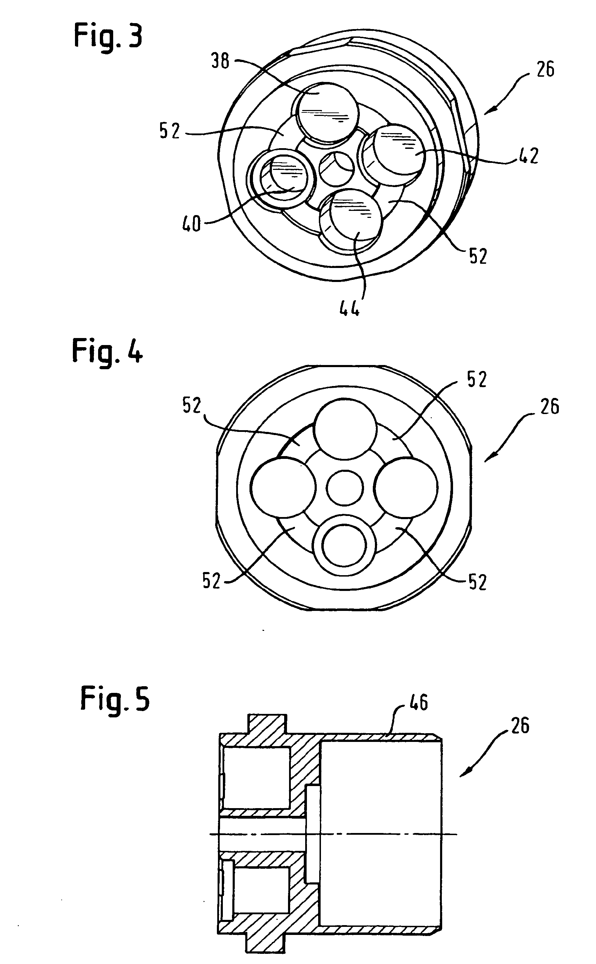

Wie insbesondere auch aus Fig. 3 bis 5 ersichtlich, sind in der Trommel 26 vier verschiedene Kalibrierstandards, nämlich ein Kurzschluss 38, ein Leerlauf 40, ein Abschlusswiderstand 42 sowie ein Fehlabschluss 44, in Umfangsrichtung gleichmäßig voneinander sowie in radialer Richtung von dem Stift 32 beabstandet derart angeordnet, dass je nach Stellung der Trommel 26 immer einer der Kalibrierstandards 38, 40, 42, 44 das zweite Ende 18 des Koaxialverbinders 10 kontaktiert. Durch Drehen der Trommel 26 um den Stift 32 relativ zur ersten Kappe 22 ist jeweils ein gewünschter Kalibrierstandard 38, 40, 42, 44 mit dem Koaxialverbinder 10 verbindbar.

Die Trommel 26 weist eine sich axial ersteckende, buchsenförmige Erhebung 46 auf, die sich in die zweite Kappe 36 hinein erstreckt. Das erste Gleitteil 28 ist zwischen dem Stift 32 und der Trommel 26 angeordnet. Das zweite Gleitteil 34 ist zwischen der buchsenförmigen Erhebung 46 der Tommel 26 und der zweiten Kappe 36 angeordnet. Beide Gleitteile 28, 34 gewährleisten eine möglichst reibungsfreie Relativbewegung der Trommel 26 relativ zum Stift 32 sowie zur zweiten Kappe 36.

Um die Anordnung aus erster Kappe 22, Trommel 26 und zweiter Kappe 36 zusammen zu halten ist der Stift 32 mit einem Ende mit der ersten Kappe 22 und mit einem gegenüberliegenden Ende mit der zweiten Kappe 36 verschraubt.

Zwischen der Trommel 26 und der zweiten Kappe 36 ist die den Stift 32 koaxial umgreifende Schraubenfeder 30 unter Vorspannung angeordnet, so dass die Trommel 26 in Richtung der ersten Kappe 22 gedrückt wird und am Außenleiter 14 des Koaxialverbinders 10 anschlägt. Dadurch wird einer der Kalibrierstandards 38, 40, 42, 44 gegen das zweite Ende 18 des Koaxialverbinders 10 gedrückt, um einen guten elektrischen Kontakt zwischen dem zweiten Ende 18 des Koaxialverbinders 10 und dem jeweiligen Kalibrierstandard 38, 40, 42, 44 herzustellen. Um die Trommel 26 zu drehen, wird diese in axialer Richtung von der ersten Kappe 22 weg in Richtung der zweiten Kappe 36 auf dem Stift 32 manuell verschoben, in dieser axial verschobenen Stellung gehalten und gleichzeitig relativ zur ersten Kappe 22 gedreht, bis ein gewünschter Kalibrierstandard 38, 40, 42, 44 mit dem zweiten Ende 18 des Koaxialsteckverbinders fluchtet. Nach dem Loslassen der Trommel 26 kehrt diese unter der Kraft der Feder 30 wieder zurück in ihre Ausgangsstellung, in der einer der Kalibrierstandards 38, 40, 42, 44 an das zweite Ende 18 des Koaxialverbinders 10 stirnseitig anschlägt und von der Feder 30 angedrückt wird.

Zusätzlich ist, wie aus Fig. 2 ersichtlich, ein Federelement 48 an der ersten Kappe 22 radial beabstandet und in radialer Richtung gegenüber dem zweiten Ende 18 des Koaxialverbinders 10 angeordnet. Dieses Federelement 48 bewirkt eine asymmetrische Krafteinwirkung auf die Trommel 26, so dass die Trommel 26 aus der nicht fluchtenden Anordnung relativ zur ersten Kappe 22 verkippt und sich ein Kontaktdruck zwischen dem zweiten Ende 18 der Koaxialsteckverbinders 10 und einem jeweiligen Kalibrierstandard 38, 40, 42, 44 ergibt. Diese zunächst nicht fluchtende Anordnung der Trommel 26 relativ zur ersten Kappe 22 ergibt sich dadurch, dass die Trommel 26 an dem Außenleiter 14 des Koaxialverbinders 10 und nicht an der Kappe 22 selbst anschlägt.

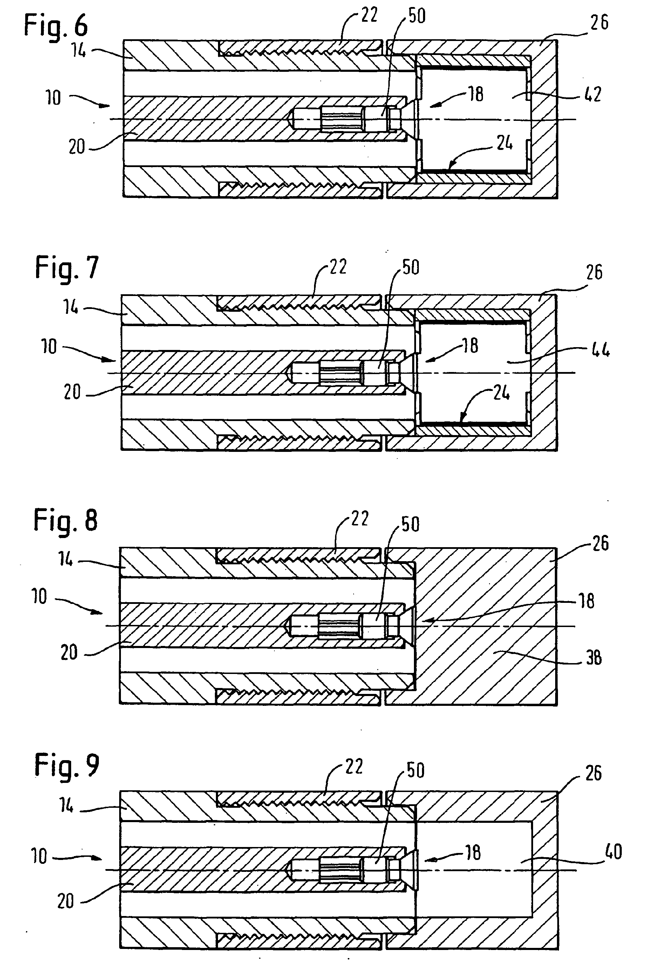

Fig. 6 bis 9 veranschaulichen vier verschiedene Kalibrierstandards und die Art und weise der jeweiligen Kontaktierung mit dem zweiten Ende 18 des Koaxialsteckverbinders 10. Hierbei ist an dem zweiten Ende 18 des Koaxialsteckverbinders 10 am Kontaktstift 20 des ansonsten in den Fig. 6 bis 9 nicht näher dargestellten Innenleiterteils ein Kontaktbolzen 50 derart angeordnet, dass dieser in axialer Richtung federnd bewegbar ist, so dass Toleranzen ausgeglichen werden. In Fig. 6 ist ein Abschluss 42, in Fig. 7 ist ein Fehlabschluss 44, in Fig. 8 ist ein Kurzschluss 38 und in Fig. 9 ist ein Leerlauf 40 dargestellt. Der Abschluss 42 und der Fehlabschluss 44 sind als Einsatzbuchsen für eine entsprechende Ausnehmung in der Trommel 26 ausgebildet. Der Leerlauf 40 ist als leere Ausnehmung in der Trommel 26 ausgebildet. Der Kurzschluss 38 ist einstückig mit der Trommel 26 ausgebildet.

An einer der ersten Kappe 22 zugewandten Seite der Trommel 26 ist, wie aus Fig. 3 und 4 ersichtlich, eine Ringnut 52 ausgebildet, welche die Aussparungen in der Trommel 26 für die Kalibrierstandards 38, 40, 42, 44 miteinander verbindet. Diese Ringnut 52 dient als Freiraum für den federbelasteten Kontaktbolzen 50 beim Drehen der Trommel 26 relativ zur ersten Kappe 22 und verhindert dadurch ein seitliches Anschlagen und ggf. Abscheren dieses Kontaktbolzens 50 am Rand einer der Ausnehmungen für die Kalibrierstandards 38, 40, 42, 44.

## Patentansprüche

1. Kalibrieradapter mit einem Koaxialverbinder (10), insbesondere Koaxialstecker oder Koaxialbuchse bzw. Koaxialkuppler, zum Anschluss an einen Koaxialverbinder eines zu kalibrierenden Gerätes, insbesondere an ein Messtor eines vektoriellen Netzwerkanalysators (VNA), wobei der Koaxialverbinder (10) ein Innenleiterteil (12), ein koaxial dazu angeordnetes Außenleiterteil (14) sowie ein mit dem Koaxialverbinder des zu kalibrierenden Gerätes verbindbares steckseitiges Ende (16) aufweist,
**dadurch gekennzeichnet,**
**dass** der Kalibrieradapter eine Trommel (26) aufweist, in der wenigstens zwei Kalibrierstandards (38, 40, 42, 44) angeordnet sind, wobei die Trommel (26) drehbar auf einem Stift (32) angeordnet ist, welcher zentrisch mit einer ersten Kappe (22) derart verbunden ist, dass eine Längsachse des Stiftes (32) mit einer Längsachse der ersten Kappe (22) fluchtet, wobei der Koaxialverbinder (10) mit einem dem steckseitigen Ende (16) gegenüberliegenden zweiten Ende (18) exzentrisch zur Längsachse der ersten Kappe (22) mit der ersten Kappe (22) verbunden ist und die Kalibrierstandards (38, 40, 42, 44) in der Trommel (26) derart angeordnet sind, dass durch Drehen der Trommel (26) relativ zur ersten Kappe (22) das dem steckseitigen Ende (16) gegenüberliegende zweite Ende (18) des Koaxialverbinders (10) wahlweise mit einem der Kalibrierstandards (38, 40, 42, 44) verbindbar ist.

2. Kalibrieradapter nach Anspruch 1, **dadurch gekennzeichnet, dass** die Trommel (26) vier verschiedene Kalibrierstandards (38, 40, 42, 44) aufweist.

3. Kalibrieradapter nach Anspruch 1 oder 2, **dadurch gekennzeichnet, dass** die Kalibrierstandards einen Kurzschluss (38), welcher das Innenleiterteil (12) des Koaxialverbinders (10) mit dem Außenleiterteil (14) des Koaxialverbinders (10) elektrisch kurz schließt, einen Leerlauf (40), einen Abschlusswiderstand (42) und/oder einen Fehlabschluss (44) umfassen.

4. Kalibrieradapter nach wenigstens einem der vorhergehenden Ansprüche, **dadurch gekennzeichnet, dass** die Kalibrierstandards (38, 40, 42, 44) in der Trommel (26) in Umfangsrichtung gleichmäßig voneinander beabstandet angeordnet sind.

5. Kalibrieradapter nach wenigstens einem der vorhergehenden Ansprüche, **dadurch gekennzeichnet, dass** das Außenleiterteil (14) mit der ersten Kappe (22) verschraubt ist.

6. Kalibrieradapter nach wenigstens einem der vorhergehenden Ansprüche, **dadurch gekennzeichnet, dass** die erste Kappe (22) mit dem Stift (32) verschraubt ist.

7. Kalibrieradapter nach wenigstens einem der vorhergehenden Ansprüche, **dadurch gekennzeichnet, dass** der Stift (32) an einem von der ersten Kappe (22) abgewandten Ende mit einer zweiten Kappe (36) verschraubt ist.

8. Kalibrieradapter nach Anspruch 7, **dadurch gekennzeichnet, dass** eine elastische Federvorrichtung (30) vorgesehen ist, welche die zweite Kappe (36) und die Trommel (26) in axialer Richtung voneinander weg mit Kraft beaufschlagen.

9. Kalibrieradapter nach Anspruch 8, **dadurch gekennzeichnet, dass** die Federvorrichtung eine Schraubenfeder (30) ist, welche koaxial zum Stift (32) angeordnet ist.

10. Kalibrieradapter nach wenigstens einem der Ansprüche 7 bis 9, **dadurch gekennzeichnet, dass** die Trommel (26) eine sich in axialer Richtung erstreckende, buchsenförmige Verlängerung (46) aufweist, welche in die zweite Kappe (36) eingreift.

11. Kalibrieradapter nach Anspruch 10, **dadurch gekennzeichnet, dass** zwischen der buchsenförmigen Verlängerung (46) der Trommel (26) und der zweiten Kappe (36) ein zweites Gleitteil (34) angeordnet ist.

12. Kalibrieradapter nach wenigstens einem der vorhergehenden Ansprüche, **dadurch gekennzeichnet, dass** zwischen der Trommel (26) und dem Stift (32) ein erstes Gleitteil (28) angeordnet ist.

13. Kalibrieradapter nach wenigstens einem der vorhergehenden Ansprüche, **dadurch gekennzeichnet, dass** zwischen der ersten Kappe (22) und der Trommel (26) ein Federelement (48) radial beabstandet von dem Stift (32) angeordnet ist, welches die Trommel (26) und die erste Kappe (22) von einander weg mit Kraft beaufschlagt.

14. Kalibrieradapter nach Anspruch 13, **dadurch gekennzeichnet, dass** das Federelement (48) radial gegenüberliegend zum Koaxialverbinder (10) angeordnet ist.

15. Kalibrieradapter nach Anspruch 13 oder 14, **dadurch gekennzeichnet, dass** das Federelement (48) an der ersten Kappe (22) befestigt ist.

16. Kalibrieradapter nach wenigstens einem der vorhergehenden Ansprüche, **dadurch gekennzeichnet, dass** wenigstens einer der Kalibrierstandards (38, 40, 42, 44) einstückig mit der Trommel (26) ausgebildet ist.

17. Kalibrieradapter nach wenigstens einem der vorhergehenden Ansprüche, **dadurch gekennzeichnet, dass** der Koaxialverbinder (10) derart mit der ersten Kappe (22) verbunden ist, dass eine Längsachse des Koaxialverbinders (10) parallel zu einer Längsachse der ersten Kappe (22) verläuft.

18. Kalibrieradapter nach wenigstens einem der vorhergehenden Ansprüche, **dadurch gekennzeichnet, dass** an einer der ersten Kappe (22) zugewandten Seite der Trommel (26) eine Ringnut (52) ausgebildet ist, welche Aussparungen in der Trommel (26) für die Kalibrierstandards (38, 40, 42, 44) miteinander verbindet.

## Claims

1. A calibration adapter with a coaxial connector (10), in particular a coaxial plug or coaxial socket or coaxial coupler, for connecting to a coaxial connector of a device to be calibrated, in particular to a measurement port of a vectorial network analyzer (VNA), wherein the coaxial connector (10) has an inner conductor part (12), an outer conductor part (14) arranged coaxially thereto, and a male termination (16) which can be connected to the coaxial connector of the device to be calibrated, **characterised in that** the calibration adapter has a drum (26) in which at least two calibration standards (38, 40, 42, 44) are arranged, wherein the drum (26) is rotatably arranged on a pin (32) which is connected centrally to a first cap (22) in such a way that a longitudinal axis of the pin (32) is flush with a longitudinal axis of the first cap (22), wherein the coaxial connector (10), with a second termination (18) opposite to the male termination (16), is connected to the first cap (22) eccentrically to the longitudinal axis of the first cap (22), and the calibration standards (38, 40, 42, 44) are arranged in the drum (26) in such a way that by rotating the drum relative to the first cap (22), the second termination (18) opposite to the male termination (16) of the coaxial conductor (10) can be optionally connected with one of the calibration standards (38, 40, 42, 44).

2. Calibration adapter according to claim 1, **characterised in that** the drum (26) has four different calibration standards (38, 40, 42, 44).

3. Calibration adapter according to claim 1 or 2, **characterised in that** the calibration standards comprise a short-circuit (38), which electrically short-circuits the inner conductor part (12) of coaxial connector (10) with the outer conductor part (14) of coaxial connector (10), a mismatch (40), a termination impedance (42) and/or a mismatch (44).

4. Calibration adapter according to at least one of the preceding claims, **characterised in that** the calibration standards (38, 40, 42, 44) are arranged in the drum (26) in circumferential direction spaced equally apart from each other.

5. Calibration adapter according to at least one of the preceding claims, **characterised in that** the outer conductor part (14) is screwed to the first cap (22).

6. Calibration adapter according to at least one of the preceding claims, **characterised in that** the first cap (22) is screwed to the pin (32).

7. Calibration adapter according to at least one of the preceding claims, **characterised in that** the pin (32) is screwed to the second cap (36) at the end of the second cap (36) facing away from the first cap (22).

8. Calibration adapter according to claim 7, **characterised in that** an elastic spring device (30) is provided which acts with force upon the second cap (36) and the drum (26) in axial direction pushing them apart.

9. Calibration adapter according to claim 8, **characterised in that** the spring device is a helical spring (30) which is arranged coaxially to the pin (32).

10. Calibration adapter according to at least one of claims 7 to 9, **characterised in that** the drum (26) has a socket-shaped extension (46) extending in axial direction, which engages in the second cap (36).

11. Calibration adapter according to claim 10, **characterised in that** a second sliding part (34) is arranged between the socket-shaped extension (46) of drum (26) and the second cap (36).

12. Calibration adapter according to at least one of the preceding claims, **characterised in that** a first sliding part (28) is arranged between the drum (26) and the pin (32).

13. Calibration adapter according to at least one of the preceding claims, **characterised in that** between the first cap (22) and the drum (26) a spring element (48) is arranged spaced radially apart from the pin (32), which acts with force upon the drum (26) and the first cap (22) pushing them apart.

14. Calibration adapter according to claim 13, **characterised in that** the spring element (48) is arranged radially opposite to the coaxial connector (10).

15. Calibration adapter according to claim 13 or 14, **characterised in that** the spring element (48) is fastened to the first cap (22).

16. Calibration adapter according to at least one of the preceding claims, **characterised in that** at least one of the calibration standards (38, 40, 42, 44) is formed in one piece with the drum (26).

17. Calibration adapter according to at least one of the preceding claims, **characterised in that** the coaxial connector (10) is connected with the first cap (22) in such as way that a longitudinal axis of coaxial connector (10) extends in parallel to the longitudinal axis of the first cap (22).

18. Calibration adapter according to at least one of the preceding claims, **characterised in that** an annular groove (52) is formed on the side of drum (26) facing the first cap (22) which connects recesses in the drum (26) for the calibration standards 38, 40, 42, 44) with each other.

## Revendications

1. Adaptateur de calibrage comprenant un connecteur coaxial (10), en particulier connecteur coaxial mâle ou connecteur coaxial femelle ou encore coupleur coaxial, destiné à être branché à un connecteur coaxial d'un appareil à calibrer, en particulier à une porte de mesure d'un analyseur de réseau vectoriel (VNA), dans lequel le connecteur coaxial (10) comprend une partie conductrice intérieure (12), une partie conductrice extérieure (14) agencée coaxialement à celle-ci, ainsi qu'une extrémité (16) coté enfichage à relier au connecteur coaxial de l'appareil à calibrer,
**caractérisé en ce que**
l'adaptateur de calibrage comprend un tambour (26) dans lequel sont agencés au moins deux standards de calibrage (38, 40, 42, 44), tels que le tambour (26) est agencé en rotation sur une tige (32), laquelle est reliée de manière centrée à un premier capuchon (22) de telle façon qu'un axe longitudinal de la tige (32) est aligné avec un axe longitudinal du premier capuchon (22), dans lequel le connecteur coaxial (10) est relié avec le premier capuchon (22) par une seconde extrémité (18) opposée à l'extrémité (16) coté enfichage de manière excentrée par rapport à l'axe longitudinal du premier capuchon (22), et les standards de calibrage (38, 40, 42, 44) sont agencés dans le tambour (26) de telle manière que par rotation du tambour (26) par rapport au premier capuchon (22), la seconde extrémité (18), opposée à l'extrémité (16) côté enfichage, du connecteur coaxial (10) peut être connectée au choix avec l'un des standards de calibrage (38, 40, 42, 44).

2. Adaptateur de calibrage selon la revendication 1, **caractérisé en ce que** le tambour (26) comprend quatre standards de calibrage différents (38, 40, 42, 44).

3. Adaptateur de calibrage selon la revendication 1 ou 2, **caractérisé en ce que** les standards de calibrage comprennent un court-circuit (38), qui met en court-circuit électrique la partie conductrice intérieure (12) du connecteur coaxial (10) avec la partie conductrice extérieure (14) du connecteur coaxial (10), un circuit ouvert (40), une résistance de terminaison (42) et/ou une terminaison d'erreur (44).

4. Adaptateur de calibrage selon l'une au moins des revendications précédentes, **caractérisé en ce que** les standards de calibrage (38, 40, 42, 44) sont agencés dans le tambour (26) à distance régulière les uns des autres en direction périphérique.

5. Adaptateur de calibrage selon l'une au moins des revendications précédentes, **caractérisé en ce que** la partie conductrice extérieure (14) est vissée avec le premier capuchon (22).

6. Adaptateur de calibrage selon l'une au moins des revendications précédentes, **caractérisé en ce que** le premier capuchon (22) est vissé avec la tige (32).

7. Adaptateur de calibrage selon l'une au moins des revendications précédentes, **caractérisé en ce que** la tige (32) est vissée avec un second capuchon (36) à une extrémité détournée du premier capuchon (22).

8. Adaptateur de calibrage selon la revendication 7, **caractérisé en ce qu'**il est prévu un dispositif à ressort élastique (30) qui sollicite le second capuchon (36) et le tambour (26) à force en éloignement l'un de l'autre en direction axiale.

9. Adaptateur de calibrage selon la revendication 8, **caractérisé en ce que** le dispositif à ressort est un ressort hélicoïdal (30) qui est agencé coaxialement par rapport à la tige (32).

10. Adaptateur de calibrage selon l'une au moins des revendications 7 à 9, **caractérisé en ce que** le tambour (26) comprend un prolongement en forme de douille (46), qui s'étend en direction axiale et qui s'engage dans le second capuchon (36).

11. Adaptateur de calibrage selon la revendication 10, **caractérisé en ce qu'**une seconde pièce coulissante (34) est agencée entre le prolongement (46) en forme de douille du tambour (26) et le second capuchon (34).

12. Adaptateur de calibrage selon l'une au moins des revendications précédentes, **caractérisé en ce qu'**une première pièce coulissante (28) est agencée entre le tambour (26) et la tige (32).

13. Adaptateur de calibrage selon l'une au moins des revendications précédentes, **caractérisé en ce qu'**un élément à ressort (48) est agencé entre le premier capuchon (22) et le tambour (26) et à distance radiale depuis la tige (32), cet élément à ressort sollicitant le tambour (26) et le premier capuchon (22) à force en éloignement l'un de l'autre.

14. Adaptateur de calibrage selon la revendication 13, **caractérisé en ce que** l'élément à ressort (48) est agencé radialement à l'opposé du connecteur coaxial (10).

15. Adaptateur de calibrage selon la revendication 13 ou 14, **caractérisé en ce que** l'élément à ressort (48) est fixé sur le premier capuchon (22).

16. Adaptateur de calibrage selon l'une au moins des revendications précédentes, **caractérisé en ce que** l'un au moins des standards de calibrage (38, 40, 42, 44) est réalisé d'une seule pièce avec le tambour (26).

17. Adaptateur de calibrage selon l'une au moins des revendications précédentes, **caractérisé en ce que** le connecteur coaxial (10) est relié au premier capuchon (22) de telle façon qu'un axe longitudinal du connecteur coaxial (10) s'étend parallèlement à un axe longitudinal du premier capuchon (22).

18. Adaptateur de calibrage selon l'une au moins des revendications précédentes, **caractérisé en ce qu'**une gorge annulaire (52) est ménagée sur un côté du tambour (26) tourné vers le premier capuchon (22), laquelle relie ensemble des échancrures dans le tambour (26) pour les standards de calibrage (38, 40, 42, 44).
